# EUROPÄISCHE PATENTSCHRIFT

(11) **EP 4 315 882 B1**
(45) Veröffentlichungstag und Bekanntmachung des Hinweises auf die Patenterteilung: **30.04.2025**
(21) Anmeldenummer: 22713958.1
(22) Anmeldetag: 21.03.2022
(51) Int. Cl.: B06B 1/06, B06B 1/02, H10N 30/20, H04R 17/00

(54) **MEMS-SCHALLWANDLER**
MEMS SOUND TRANSDUCER
TRANSDUCTEUR ACOUSTIQUE MEMS

(30) Priorität: 01.04.2021 DE 102021203360
(43) Veröffentlichungstag der Anmeldung: 07.02.2024
(73) Patentinhaber: Fraunhofer-Gesellschaft zur Förderung der angewandten Forschung e.V., 80686 München (DE)
(72) Erfinder: NIEKIEL, Malte Florian, 25524 Itzehoe (DE); STOPPEL, Fabian, 25524 Itzehoe (DE); WAGNER, Bernhard, 25524 Itzehoe (DE); LOFINK, Fabian, 25524 Itzehoe (DE)
(74) Vertreter: Pfitzner, Hannes
(86) Internationale Anmeldenummer: PCT/EP2022/057295
(87) Internationale Veröffentlichungsnummer: WO 2022/207384

(56) Entgegenhaltungen:
- DE-A1- 102013 013 402
- US-A1- 2011 182 150
- US-A1- 2016 211 439
- US-B2- 10 567 883

## Beschreibung

Ausführungsbeispiele der vorliegenden Erfindung beziehen sich auf einen MEMS-Schallwandler. Bevorzugte Ausführungsbeispiele beschreiben einen Mikrolautsprecher in MEMS-Technologie.

Als Weiterentwicklung konventioneller Lautsprecher sind Mikrolautsprecher aus einer Miniaturisierung des etablierten elektrodynamischen Antriebs hervorgegangen. Bei der am weitesten verbreiteten Tauchspulenanordnung ist eine Spule auf der Rückseite der Membran befestigt, die sich beim Anlegen eines Stromsignals in dem Magnetfeld eines festen Permanentmagneten bewegt und so die Membran auslenkt.

Eine Entwicklung aus den Hörgerätanwendungen sind die sogenannten Balanced-Armature-Wandler (BA-Wandler). Ein spulenumwickelter Stab befindet sich im Spalt eines ringförmigen Permanentmagneten und ist mit einer Membran verbunden. Ein Stromsignal auf die Spule magnetisiert den Stab, auf den dann durch das Magnetfeld des Permanentmagneten ein Drehmoment wirkt. Die Drehung wird über eine starre Verbindung auf die Membran übertragen. Der Stab befindet sich im Grundzustand in einem instabilen Gleichgewicht der magnetischen Anziehungskräfte. Durch diesen instabilen Zustand können mit geringem Aufwand (Antriebskräfte, Energie) höhere Auslenkungen erreicht werden. BA-Wandler zeichnen sich daher durch höhere erreichbare Schalldruckpegel aus und werden auf Grund ihrer Baugröße bevorzugt für in-ear Anwendungen genutzt.

Getrieben durch die Anforderung der Miniaturisierung und beflügelt durch die Erfolge auf dem Gebiet der Mikrofone hat sich die Mikrosystemtechnik dem Thema der Mikrolautsprecher angenommen. Eine Entwicklung des Fraunhofer ISIT zusammen mit der Firma USound resultierte in einen MEMS-Lautsprecher auf Basis von piezoelektrischen Biegeaktoren, die eine hybrid aufgebrachte Membran auslenken [1]. Ein Lautsprechermodul mit den Abmaßen 5,4 mm x 3,4 mm x 1,6 mm erreicht über einen Frequenzbereich von 20 Hz - 20 kHz im abgeschlossenen Volumen einen Schalldruckpegel *SPL*_{1.4*cm*³} von mindestens 106 dB (ca. 116 dB bei 1 kHz) [2].

Eine Weiterentwicklung dieses Ansatzes sind MEMS-Lautsprecher auf Basis piezoelektrischer Biegeaktoren, die ohne zusätzliche Membran auskommen, entwickelt am Fraunhofer ISIT. Hier bilden die Aktoren selbst die akustisch abstrahlende Membran. Ein Lautsprecherchip mit einer aktiven Fläche von 4 mm x 4 mm erreicht im abgeschlossenen Raum einen Schalldruckpegel *SPL*_{1.26*cm*³} von mindestens 105 dB (ca. 110 dB bei 1 kHz) [3].

Es sind auch verschiedene Konzepte elektrodynamisch betätigter MEMS-Lautsprecher bekannt. Erwähnenswert sind insbesondere die Arbeiten an der Université Paris-Sud und der Université du Maine [4,5]. Eine an Si-Federn aufgehängte versteifte Si-Membran bildet einen Kolbenschwinger. Die Spule ist als Planarspule direkt auf die Si-Membran aufgebracht und bewegt die Membran im Magnetfeld eines hybrid aufgebrachten Permanentmagneten. Ein verwandter Ansatz, verfolgt von mehreren Gruppen [6,7,8,9,10,11], besteht darin, dass die Planarspule auf eine weiche Polymermembran anstelle der versteiften Si-Membran aufgebracht wird. Darüber hinaus gibt es einigen Stand der Technik aus der Patentliteratur.

Die US 10,567,883 B2 offenbart MEMS-Schallwandler. Darüber hinaus sind die US 2011/182150 A1, US 2016/211439 A1 und DE 10 2013 013 402 A1 zu nennen.

Das Konzept eines magnetostriktiv getriebenen Mikrolautsprechers wird von Albach et al. [12] verfolgt. Der Schallwandler besteht hier aus einem zweiteiligen Aufbau. Den ersten Teil bildet ein Mikrolautsprecher-Chip, der die magnetostriktive Membran des Lautsprechers trägt. Die Membran selber besteht aus vielen einzelnen Biegebalken. Deren Schichtaufbau besteht aus einer magnetostriktiven (aktiven) sowie weiteren passiven Schichten. Bei Anlegen eines Magnetfelds biegen sich diese Mikroaktoren aus der Ebene des Chips und verdrängen so Luft, wodurch Schalldruck erzeugt wird. Den zweiten Teil des Mikrolautsprechers bildet eine stromdurchflossene Spule, die das zum Betrieb benötigte Magnetfeld erzeugt. Das hier vorgeschlagene Konzept sieht dazu einen zweiten Chip vor, der entsprechende Mikroflachspulen trägt.

Ein weiteres Mikrolautsprecher Konzept basiert auf dem nanoskopischen elektrostatischen Antrieb (nanoscopic electrostatic drive, NED) [13]. Das Bauelement umfasst geklemmte elektrostatische Biegeaktoren; die paarweise in Zeilen und Spalten innerhalb der Bauelementschicht eines SOI-Wafers (Silicon on Insulator) angeordnet und mit einem weiteren Wafer bedeckt sind, welcher mit einem winzigen Abstand auf den SOl-Wafer gebondet ist. Zwischen jeder benachbarten Reihe von Aktuatoren/Aktoren sind akustisch wirksame Öffnungen abwechselnd in die Ober- und Unterseite des Wafers integriert, um die Abstrahlung von Schall aus dem Bauelement ohne akustischen Kurzschluss zu ermöglichen.

Ein weiterer piezoelektrisch angetriebener Mikrolautsprecher wurde von der Firma xMEMS vorgestellt. Hier wird eine Silizium Membran piezoelektrisch angetrieben und in Schwingung versetzt [14].

Die besten Ergebnisse wurden bisher für Mikrolautsprecher mit piezoelektrischem Antrieb beobachtet. Bei MEMS Lautsprechern, z. B, die einen piezoelektrisch angetriebenen Biegeaktor aufweisen, ist der begrenzende Faktor die Abstrahlfläche des Biegeaktors. Deshalb besteht der Bedarf nach einem verbesserten Ansatz.

Aufgabe der vorliegenden Erfindung ist es, ein Konzept zu schaffen, das einen verbesserten Kompromiss aus Herstellbarkeit, Abstrahlcharakteristik und Abstrahlfläche (erzielbaren Schalldruck) aufweist.

Die Aufgabe wird durch den Gegenstand der unabhängigen Patentansprüche gelöst.

Ausführungsbeispiele der vorliegenden Erfindung schaffen einen MEMS-Schallwandler mit mindestens einem Aktor (z.B. Biegeaktor auf Piezobasis), einer Abstrahlstruktur (z.B. in Form einer starren Platte) und einer die Abstrahlstruktur umgebenden Struktur. Die Abstrahlstruktur ist als separates Element mit dem Aktor gekoppelt und ausgebildet, um bei Betätigung durch den Aktor Schall zu emittieren. Die die Abstrahlstruktur umgebende Struktur ist durch einen Spalt oder mehrere Spalten von der umgebenden Struktur getrennt. Ferner umfasst der MEMS-Schallwandler zumindest eine Blende, die entlang zumindest eines der einen oder mehreren Spalte angeordnet ist bzw. sich erstreckt.

Ausführungsbeispielen der vorliegenden Erfindung liegt die Erkenntnis zugrunde, dass durch Trennung der Antriebsfunktion und Luftverdrängungsfunktion eine Optimierung der Lautsprecher-Performance erreicht werden kann. Die Trennung der Antriebsfunktionalität (mindestens ein Aktor) und der Luftverdrängungsfunktionalität (Abstrahlstruktur) erfolgt durch Verwendung von separaten Komponenten, die sich unabhängig voneinander optimieren lassen. Die zur Luftverdrängung genutzte aktive Fläche lässt sich beispielsweise in Richtung einer starren Plattform mit gleichförmiger Hubbewegung optimieren, wobei sich die maximale Auslenkung des Antriebs besser in verdrängtes Volumen umsetzen lässt. Weiter ist die für den Antrieb verwendete aktive Fläche auf spezifische Gegebenheiten des verwendeten Antriebskonzepts optimierbar. Somit lassen sich Mikrolautsprecher im MEMS-Technologie auslegen, die je nach Auslegung folgende Vorteile nutzt:
▪ Höherer Schalldruckpegel durch bessere Luftverdrängung
▪ Geringerer Energieverbrauch durch optimierte aktive Fläche des Antriebs
▪ Geringere Verzerrungen durch bessere Linearität des optimierten Antriebs
▪ Geringere Antriebsspannung durch längere Biegeaktoren

Auf diese Weise können bei Mikrolautsprechern höhere Schalldruckpegel bei geringerem Energieaufwand oder bei gleichbleibenden oder kleineren Baumaßen erreicht werden.

Entsprechend einem Ausführungsbeispiel kann die Abstrahlungsstruktur dazu ausgebildet sein, bei Betätigung durch den Aktor eine Hubbewegung in eine Richtung aus der Substratebene heraus durchzuführen. Hierbei ist dann beispielsweise die Abstrahlungsstruktur zusammen mit der umgebenden Struktur in einer Ebene angeordnet. Beispielsweise kann die umgebende Struktur durch ein Substrat gebildet sein, und die Abstrahlstruktur sich in der oder parallel zu der Substratebene erstrecken und/oder in einer Kavität des Substrats angeordnet sein. Die Trennung zwischen Abstrahlstruktur und umgebender Struktur kann, wie bereits erwähnt, durch eine oder mehrere Spalten vorgesehen sein. Diese können umlaufend sein. Durch diese umlaufende Charakteristik wird eben die Hubbewegung ermöglicht, was bei konventionellen Biegeaktoren nicht möglich ist. Eine Hubbewegung ist wesentlich effizienter, da so auf die gesamte Biegeaktorfläche gesehen mehr Luft verdrängt werden kann.

Entsprechend Ausführungsbeispielen kann die Abstrahlstruktur gegenüber der umgebenden Struktur im Ruhezustand ausgebildet sein. Die umgebenden Struktur kann entsprechend Ausführungsbeispielen ruhend sein, d.h. dass sie nicht aktiv zur Schwingung angeregt wird. Die Abstrahlstruktur bewegt sich hingegen gegenüber der umgebenen (ruhenden / unbeweglichen) Struktur. Über die unbeweglichen umgebenen Struktur kann der Schallwandler mit einer Trägerkomponente (Leiterplatte, elektrischen Komponente, etc. Verbunden sein).

Bezüglich der akustischen Separierung der umgebenden Struktur und der Abstrahlstruktur sei angemerkt, dass eine oder mehrere Blenden verwendet werden, die eine akustische Entkopplung des Rückvolumens der Abstrahlstruktur ermöglichen. Entsprechend Ausführungsbeispielen ist zumindest eine Blende als Teil der Abstrahlstruktur geformt. Additiv oder alternativ kann sich die zumindest eine Blende in die Substratebene hineinerstrecken, z. B. senkrecht. Alternativ oder additiv kann die Blende als Teil der umgebenden Struktur geformt sein. Hierbei kann sich beispielsweise die Blende aus der Substratebene herauserstrecken, z. B. senkrecht. Entsprechend Ausführungsbeispielen kann die Blende durch eine Kavität der umlaufenden Struktur geformt sein.

Wie oben bereits erläutert, ist bevorzugterweise der Spalt umlaufend. Entsprechend einem weiteren Ausführungsbeispiel kann auch die Blende umlaufend um die Abstrahlstruktur oder entlang der einen oder mehreren Spalten angeordnet sein.

Bezüglich des Aktors sei angemerkt, dass dieser entsprechend einem bevorzugten Ausführungsbeispiel als Biegeaktor, Längsbiegeaktor oder als Biegeaktor mit einem hohen Aspektverhältnis vorgesehen ist. Ein solcher Biegeaktor ermöglicht hohe Hubbewegungen, zumindest des vorderen Endes. Bei piezoelektrischen Biegeaktoren beispielsweise können also längere Aktoren eingesetzt werden, um höhere maximale Auslenkung zu erreichen. Die Begrenzung der Breite sorgt hierbei für eine geringere kapazitive Last.

Typischerweise sind Biegeaktoren (beispielsweise) mit einem freien Ende versehen und weisen (z. B. gegenüberliegend) ein eingespanntes Ende auf. Entsprechend einem Ausführungsbeispiel ist die Abstrahlstruktur mit dem freien Ende des Biegeaktors gekoppelt. Das kann zum Beispiel dadurch erfolgen, dass im Bereich des freien Endes eine Ankopplung der Abstrahlstruktur vorgesehen ist. In Längsrichtung gesehen kann der Biegeaktor beispielsweise im vorderen Drittel (d. h. in Längsrichtung im Drittel) näher am freien Ende als am eingespannten Ende angekoppelt sein. Hierdurch wird vorteilhafterweise ermöglicht, dass der maximale Hub auf die Abstrahlstruktur übertragen wird. Der Aktor bzw. Biegeaktor kann beispielsweise ein piezoelektrisch angetriebener Biegeaktor sein. Alternativ wäre natürlich auch einer elektrodynamisch oder elektrostatisch angetriebener Aktor denkbar. Der Biegeaktor verfügt im Regelfall sowohl über eine Aufhängungsfunktion als auch über eine Antriebsfunktion in Bezug auf die Abstrahlstruktur.

Entsprechend einem Ausführungsbeispiel kann die Abstrahlstruktur über der umgebenden Struktur durch weitere Elemente, wie z. B. Federelemente oder Federn gelagert sein.

Ein bevorzugtes Ausführungsbeispiel gestaltet sich wie folgt. Die Abstrahlstruktur umfasst zwei oder mehr, wie z. B. vier Bereiche. Zwischen den zwei oder mehr Bereichen ist ein zentraler weiterer Bereich vorgesehen. Entsprechend einem Ausführungsbeispiel kann der mindestens eine Aktor oder mehrere Aktoren in dem zentralen Bereich mit der Abstrahlstruktur gekoppelt sein bzw. an diesem angreifen. Wenn man entsprechend weiteren Ausführungsbeispielen davon ausgeht, dass vier als Quadranten angeordnete Bereiche vorgesehen sind, so können entsprechend Ausführungsbeispielen die vier als Quadranten angeordneten Bereiche durch vier Aufhängungselemente bzw. vier Aktoren/Biegewandler (als Teil der Aufhängung und als Antrieb) unterbrochen sein. Die Aufhängungselemente oder Aktoren sind mit einem zentralen Bereich zwischen den vier Quadranten gekoppelt. Durch diese Anordnung wird die Kraft von vier Aktoren gebündelt und die Fläche von vier Quadranten maximiert. Durch den zentralen Angriff kommt es zu einer Hubbewegung, die aus Effizienzsicht vorteilhaft ist.

Weiterbildungen sind in den Unteransprüchen definiert. Ausführungsbeispiele der vorliegenden Erfindung werden anhand der beiliegenden Zeichnungen erläutert. Es zeigen:
Fig. 1 eine schematische Darstellung eines MEMS-Schallwandlers gemäß einem Basisausführungsbeispiel;
Fig. 2a, 2b schematische Darstellungen von einem MEMS-Schallwandler zur Illustration von Blenden zwischen Plattform und Substrat sowie Plattform und Aktor gemäß Ausführungsbeispielen;
Fig. 3a, 3b schematische Darstellungen für die Illustration von Blenden zwischen Plattform und Aktor sowie Substrat und Aktor gemäß Ausführungsbeispielen; und
Fig. 4a, 4b schematische Darstellungen von Aktoren unterhalb der Plattform mit Blenden zwischen Aktor und Substrat gemäß weiteren Ausführungsbeispielen.

Bevor nachfolgend Ausführungsbeispiele der vorliegenden Erfindung anhand der beiliegenden Zeichnungen erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

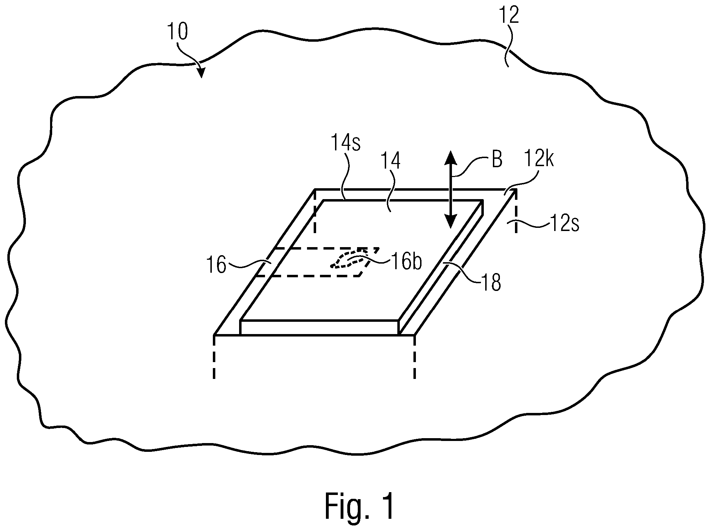

Fig. 1 zeigt einen MEMS-Schallwandler 10, der beispielsweise in einem Substrat 12 eingebracht ist. Das Substrat 12 weist eine Kavität 12k auf. In dieser Kavität 12k ist eine schallabstrahlende Fläche 14 vorgesehen. Die schallabstrahlende Fläche ist durch einen Spalt 14s, der hier exemplarisch umlaufend um die schallabstrahlende Fläche 14 angeordnet ist, von der die schallabstrahlende Fläche 14 umgebenden Struktur 12s separiert. Die die schallabstrahlende Fläche umgebende Struktur 12s ist im Wesentlichen durch das Substrat 12 bzw. die Wände der Kavität 12k geformt.

Die schallabstrahlende Fläche 14 wird gegenüber der umgebenden Struktur 12s durch einen Biegeaktor 16 bzw. allgemein einem Aktor 16 gelagert. Die Lagerung ist derart, dass die schallabstrahlende Struktur 14 sich ungefähr in der Substratebene befindet bzw. sich aus der Substratebene heraus bewegen kann (was mit dem Pfeil, der mit dem Bezugszeichen B versehen ist, illustriert ist). Hierzu ragt der Aktor 16 von dem Rand der Kavität 12k in die Kavität 12k herein, wobei in dem Bereich 16b die schallabstrahlende Fläche 14 mit dem Aktor 16 verbunden ist. Der Bereich 16b ist beispielsweise im vorderen Drittel des Biegeaktors 16 vorgesehen.

In diesem Ausführungsbeispiel ist die schallabstrahlende Fläche 14 als flaches Element, wie z. B. als flaches Rechteck oder flache Scheibe geformt. Der Spalt 14s ist möglichst gering, um aufgrund von laminarer Strömung an einem sehr geringen Spalt das Rückvolumen gut zu separieren. Um diesen Effekt zu verbessern, ist beispielsweise im Randbereich der schallabstrahlenden Fläche 14 eine Blende 18 vorgesehen. Die Blende erstreckt sich beispielsweise senkrecht zu der schallabstrahlenden Fläche 14, z. B. in die Substratebene hinein. Entsprechend Ausführungsbeispielen kann diese Blende 18 umlaufend um die Abstrahlfläche 14 sein. Es sei an dieser Stelle gleich angemerkt, dass unterschiedliche Formen der Blende 18 denkbar wären, z. B. auf der Unterseite der schallabstrahlenden Fläche 14, auf der Oberseite, im Bereich der umgebenden Struktur.

Im Allgemeinen ist entsprechend Ausführungsbeispielen die Blende im Bereich bzw. längs des Spalts 14s angeordnet, da dieser für einen akustischen Kurzschluss verantwortlich ist bzw. bei richtiger Dimensionierung desselben einen akustischen Kurzschluss verhindern kann. Der technische Effekt der Blende liegt darin, dass auch bei Hub, hier ein Kolbenhub, der schallabstrahlenden Fläche 14 entlang der Bewegungsrichtung B der Spalt 14s variiert. Durch das Vorsehen der Blende kann erreicht werden, dass dieser Spalt möglichst konstant bleibt. Durch den Kolbenhub ist es ferner möglich, dass der Spalt 14s sehr klein ist, da neben der vertikalen Bewegung aus der Substratebene heraus (vgl. B) kaum ein großer Bewegungsanteil vorliegt. Hintergrund hierzu ist, dass der Biegeaktor 16 zwar typischerweise eine translatorische Verformung durchführt. Da die schallabstrahlende Fläche 14 allerdings im vorderen Drittel befestigt ist (vgl. Bezugszeichen 16b) wird insbesondere der Hubanteil der Bewegung auf die schallabstrahlende Fläche übertragen. Der Effekt kann noch verbessert werden, wenn beispielsweise zwei Biegeaktoren gegenüberliegend angeordnet sind, so dass hier der Anteil der radialen Bewegung weiter reduziert wird. Auch das kann selbstverständlich durch drei beispielsweise im 120-Grad-Winkel angeordnete Aktoren oder einer anderen Aktoranordnung, die es ermöglicht alle Bewegungsanteile außer der Hubbewegung zu reduzieren, erreicht werden.

Insbesondere ermöglicht die Kopplung von Abstrahlfläche 14 bzw. luftverdrängender Fläche 14 und der Fläche des Antriebs 16 eine Optimierung der mittleren Auslenkung der aktiven Fläche 14 und somit das Erreichen höherer Schalldruckpegel bei gleichbleibenden oder kleineren Baumaßen. Die akustische Funktion der luftverdrängenden Fläche 14 wird idealerweise/entsprechend Ausführungsbeispielen optionaler Weise als starre Platte ausgelegt, die eine gleichmäßige vertikale Hubbewegung B ausführt, im Detail heißt das, die Auslenkung jedes Punktes auf der luftverdrängenden Fläche 14 ist zu jedem Zeitpunkt gleich. Für die Biegeaktoren 16 ist eine mögliche längliche Bauform optimal, da sich dadurch die erreichten Auslenkungen maximieren und eine bessere Linearität erzielen lassen. Der längliche Aktor hat beispielsweise ein Aspektverhältnis von 5:1. Da die maximale Auslenkung des Aktors 16 an seiner Spitze auftritt, ist die Ankopplung an die starre Platte 14 an dieser Stelle 16b durch eine geeignete Struktur, wie z. B. eine flexible Struktur, vorzunehmen. Eine optimierte Geometrie wäre somit eine an möglichst langen Biegeaktoren 16 aufgehängte starre Platte 14, die eine Hubbewegung B ausführt. Der Gewinn ergibt sich aus der Entkopplung der für beide Funktionen genutzten Fläche. Die mittlere Auslenkung der luftverdrängenden Fläche nutzt die maximale Auslenkung der Biegeaktoren 16. Zusätzlich lässt sich das Verhältnis der für die Luftverdrängung genutzten Fläche zur für die Biegeaktoren verwendeten Fläche frei wählen und somit optimieren.

In den piezoelektrischen Biegeaktoren, die hier in dem Ausführungsbeispiel zum Einsatz kommen, sind auch andere Antriebsarten, wie etwa mechanische Antriebsarten oder elektromagnetische Antriebe denkbar. In diesem Fall sind die Anforderungen an die für den Antrieb notwendigen Fläche 16 unterschiedlich. Eine Verbindung der optionaler Weise als starre Platte ausgelegten luftverdrängenden Fläche über eine Federaufhängung mit Substrat wäre eine Variante. Diese Federaufhängung ähnelt den oben beschriebenen piezoelektrischen Biegeaktoren.

Bei dem oben beschriebenen Konzept kommt es zu starken Relativbewegungen zwischen der luftverdrängenden Platte 14, den Biegeaktoren 16 oder der Federaufhängung und einem Substrat 12, an dem die Platte über die Biegeaktoren 16 oder Federn aufgehängt ist.

An den Kanten der Platte 14 kann es bei Auslenkung zur Öffnung der Spalte 14s kommen, die zu einem akustischen Kurzschluss zwischen Vorder- und Rückvolumen des Mikrolautsprechers führen kann. Diese lassen sich verhindern bzw. optimieren, indem die Trennung der Elemente als schmale Spalte ausgeführt wird. Um eine Vergrößerung dieser Spalte auch bei großen Auslenkungen zu verhindern, werden zusätzliche Blendenstrukturen 16b eingesetzt. Die Blendenstrukturen können jeweils sowohl auf dem Substrat 12 als auch der beweglichen Platte 14 oder den sich verformenden Biegeaktoren 16 oder Federstrukturen aufgebracht werden. Je nach Ausführung des Konzepts wird das Vorsehen von Blenden zwischen Plattform 14 und Substrat 12, zwischen Plattform 14 und Feder/Aktor 16 und zwischen Feder/Aktor 16 und Substrat 12 berücksichtigt. Es sei an dieser Stelle angemerkt, dass unter Ausnutzung der Kavität 12k, in der die Plattform 14 und die Aktoren 16/Federn aufgehängt sind, auch das Substrat selbst als Blende fungieren kann. Abhängig von der Bewegungsrichtung sind die Blenden 16b beispielsweise jeweils nach oben und/oder unten ausgebildet. Eine Vorauslenkung der Plattform entsprechend Ausführungsbeispielen erlaubt die Ausgestaltung der Blenden 14b in nur eine Richtung, z. B. nach oben oder unten.

Bei einer derartigen Vorauslenkung wird die mechanische Beanspruchung der Federn/Aktoren 16 berücksichtigt. Insbesondere ist hier die Verkürzung der Aktoren/Federn in lateraler Richtung zu beachten, die durch die geeignete Kopplungsstruktur erlaubt ist. Insofern ermöglicht die Kopplungsstruktur 16b, eine Aufweitung der Schlitze in lateraler Richtung zu verhindern.

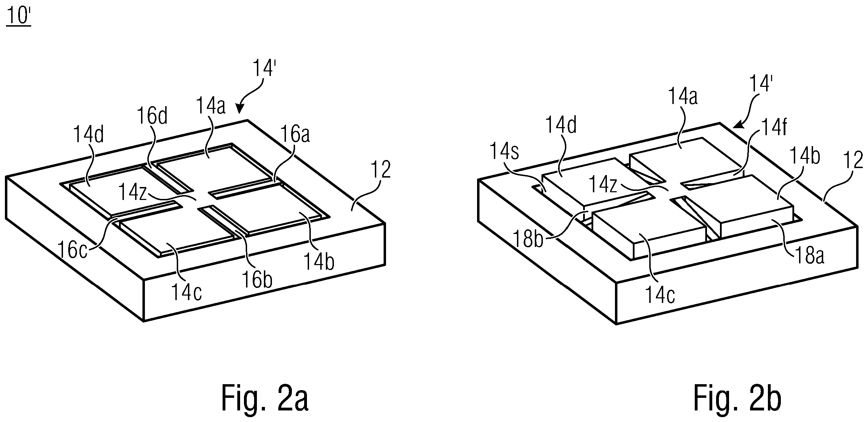

Nachfolgend wird ein erweitertes Ausführungsbeispiel Bezug nehmend auf Fig. 2 erläutert. Fig. 2 zeigt einen MEMS-Schallwandler 10', der in der Darstellung A unausgelenkt und in der Darstellung B ausgelenkt ist. Der MEMS-Schallwandler weist eine umgebende Struktur 12, eine Abstrahlfläche 14' auf, die vier Quadranten 14a bis 14d aufweist. Angetrieben wird in diesem Ausführungsbeispiel die Fläche 14' über vier Aktoren 16a bis 16d. Diese sind zwischen den Quadranten 14a-14d angeordnet und zwar wie folgt. Im Detail: 16a ist zwischen 14a und 14b, 16b zwischen 14b und 14c, 16c zwischen 14c und 14d und 16d zwischen 14d und 14a vorgesehen. Hierzu ist dann jeweils zwischen den Quadranten 14a bis 14d eine Art Schlitz vorgesehen. Dieser Schlitz ist rein exemplarisch mit Bezugszeichen 14f in Fig. 2b versehen.

Die Biegeaktoren 16a bis 16d greifen an einen zentralen Punkt der Abstrahlfläche an. Der zentrale Punkt bzw. die zentrale Fläche ist mit dem Bezugszeichen 14z versehen und verbindet die vier Quadranten 14a bis 14d. Wie in Fig. 2b zu erkennen ist, weist die Abstrahlstruktur 14' ein oder mehrere Blenden 18 auf. Die Blenden 18a, auch als außenliegende Blenden bezeichnet, sind im Bereich des Spalts 14s angeordnet und erstrecken sich von der Abstrahlfläche 14' gesehen nach unten in das Substrat 12, so dass bei Auslenkung nach in Hubrichtung B weiterhin die Spaltbreite konstant bleibt. Die mehreren Blenden 18a sind z.B. an jedem Quadranten an den äußeren Kanten, d. h. also an der dem Substrat 12 zugewandten Seite (d. h. also 4x2) vorgesehen. Weitere Blenden 18b, auch als innenliegende Blenden bezeichnet, sind auch an der Innenseite im Bereich 14f, d.h. angrenzend zu den Biegewandlern 16a bis 16d vorgesehen. Entsprechend Ausführungsbeispielen können auch nur die Blende 18a oder 18b eingesetzt werden.

Wie hier zu erkennen ist, kommt es bei Auslenkung zu einer Hubbewegung der abstrahlenden Einheit 14, was dadurch entsteht, dass jeder Biegeaktor 16a bis 16d zu einer Auslenkung des Elements 14z führt, wobei die Longitudinalkräfte sich durch die gegenüberliegende Anordnung der Aktoren 16a und 16c bzw. 16b und 16d ausgleichen.

Wie hier gut zu erkennen ist, ist die Abstrahlfläche 14 durch die vier Quadranten 14a, 14b, 14c und 14d, sowie das zentrale Element 14z signifikant größer als eine Abstrahlfläche resultierend aus den Biegeschallwandlern 16a bis 16d. Ferner sind die Biegeschallwandler 16a bis 16d lang ausgelegt, um einen ausreichend hohen Hub am Ende des Biegewandlers, d. h. also gegenüberliegend zum eingespannten Ende (Übergang 16a bis 16d zu 12) zu erreichen. Durch diese Anordnung können die Elemente 14' sowie 16a bis 16d unabhängig voneinander optimiert werden. Entsprechend Ausführungsbeispielen wäre es natürlich auch denkbar, dass statt der vier Biegewandler 16a bis 16d auch nur zwei, drei oder auch mehr Biegewandler zum Einsatz kommen. Abhängig davon ändert sich dann die Geometrie der Elemente 14a bis 14d. An dieser Stelle sei angemerkt, dass einige Komponenten, wie z. B. die außenliegenden Blenden 18a oder die innenliegenden Blenden 18b auch anders angeordnet sein können.

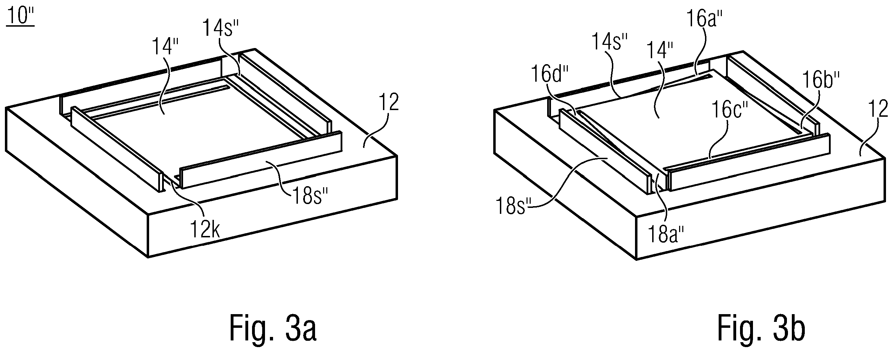

Denkbar wäre z. B., dass statt der (senkrechten) Blenden 18a und 18b an der auslenkbaren Struktur 14 alternativ oder additiv auch Blenden im Substratbereich 12, z. B. entlang des Spalts 14s, der die Abstrahlstruktur 14' umgibt, angeordnet sein können. Auch können sich die Blenden nicht nur in das Substratende hinein, sondern auch aus dem Substratende heraus erstrecken. Eine derartige Anordnung ist in Fig. 3 gezeigt.

Fig. 3 zeigt ein MEMS-Schallwandler 10" mit einer Abstrahlstruktur 14", die hier als rechteckige Fläche vorgesehen ist. Die Abstrahlstruktur 14" ist gegenüber dem Substrat 12 durch vier Aktoren 16a" bis 16d" gelagert. Die Aktoren 16a" bis 16d" erstrecken sich entlang der Außenkante der Abstrahlstruktur 14", sind also in dem Spalt 14s" angeordnet. Alle Aktoren 16a" bis 16d" sind wiederum längs angeordnet und an den äußersten Enden des länglichen Aktors mit dem Substrat 12 bzw. der Abstrahlstruktur 14" verbunden. Hierdurch ergibt sich wiederum der Vorteil einer großen Abstrahlfläche der Abstrahlstruktur 14" und langer Aktoren bzw. Biegeaktoren 16a" bis 16d", die im Resultat einen großen Hub haben. Durch die Anordnung der Aktoren 16a" bis 16d", die gegenüberliegend orientiert sind (vgl. 16a" und 16c" bzw. 16b" und 16d") kommt es nicht nur zu einer geringen Verkippung der Abstrahlstruktur 14", sondern auch insbesondere zu einem großen Hubanteil der Auslenkung.

Bezüglich der Blenden sei angemerkt, dass diese hier sowohl im Bereich der Abstrahlstruktur 14" als auch im Bereich des Substrats 12 angeordnet sein können. Exemplarisch sind hier beide Varianten illustriert, wobei eine Variante grundsätzlich auch ausreichen würde. Es sei angemerkt, dass entsprechend Ausführungsbeispielen die Ausführung mit beiden Blendenvarianten bevorzugt wäre, da sich sowohl der Spalt zwischen Aktor und Substrat als auch zwischen Aktor und Abstrahlfläche sonst aufweitet.

Wie anhand der ausgelenkten Version 3b zu erkennen ist, befinden sich die Blenden 18a" auf der Außenseite bzw. umlaufend um die schallabstrahlende Struktur 14". In diesem Fall, bei der viereckigen schallabstrahlenden Struktur 14 " mit den vier Kanten, sind also beispielsweise vier Blenden 18a" vorgesehen. Diese dichten gegenüber dem Spalt 14s", und hier insbesondere den Spalt zwischen dem Biegeaktor 14a"/14b"/14c"/14d" und der schallabstrahlenden Struktur 14", ab. Um den Bereich zwischen dem Aktor 14a"/14b"/14c"/14d" und dem Substrat 12 abdichten zu können, sind weitere Blenden 18s" vorgesehen. Diese Blenden verlängern den Rand der Kavität 12k im Substrat 12 aus der Substratebene heraus. Die Elemente 18s" wirken beispielsweise mit der Seitenwand der Kavität 12k zusammen und ermöglichen so, dass ausgehend von der Ruhelage in Fig. 3a sowie der Auslenkung nach oben als auch bei Auslenkung nach unten der abstrahlenden Struktur 14" der Spalt konstant klein gehalten wird.

Die Blende 18s" kann, wie hier dargestellt, im Bereich der fest eingespannten Enden der Biegeaktoren 16a", 16b", 16c" bzw. 16d" unterbrochen sein.

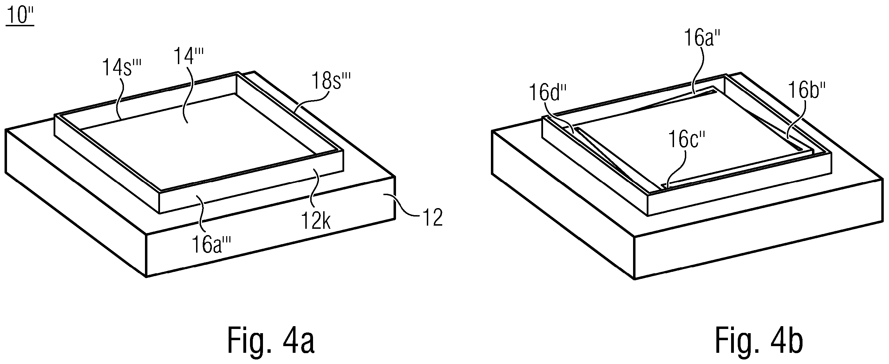

Eine etwas veränderte Konfiguration ist in Fig. 4 dargestellt, bei der die außenliegende Blende vergleichbar mit 18s" ununterbrochen ist, um so die Abdichtung weiter zu verbessern.

Fig. 4 zeigt einen MEMS-Schallwandler 10‴, bei welchem eine schallabstrahlende Struktur 14‴ in einer Kavität 12k des Substrats 12 angeordnet ist. Die schallabstrahlende Struktur 14‴ ist bezüglich Form und Position vergleichbar mit der schallabstrahlenden Struktur 14" und kann ebenfalls Blenden vergleichbar zu der Blende 18a" aufweisen. In diesem Fall ist es allerdings so, dass eine oder mehrere Biegeaktoren unterhalb der schallabstrahlenden Struktur 14‴ vorgesehen sind. Diese sind mit den Bezugszeichen 16a‴ bis 16d‴ versehen. Im Gegensatz zum Ausführungsbeispiel aus Fig. 3 befinden sich die Elemente unterhalb der schallabstrahlenden Struktur 14‴, so dass die Fläche der schallabstrahlenden Struktur 14‴ weiter optimiert wird. Dadurch entsteht dann auch nur ein Spalt 14s‴ um die schallabstrahlende Struktur 14‴ herum. Dieser Spalt wird beispielsweise unter Verwendung der Blende 18s‴ abgedichtet.

Das Ausführungsbeispiel aus Fig. 4 ermöglicht also vorteilhafterweise, dass eine vertikale Anordnung der Federn/Aktoren 16a‴ bis 16d‴ und der schallabstrahlenden Struktur 14‴ vorgesehen wird. Die Federn/Aktoren 16a‴ werden ober- oder unterhalb der Plattformebene mit der Plattform verbunden. Dies erlaubt die Unterbringung der Federn/Aktoren 16a‴ bis 16d‴ ohne zusätzlichen Flächenbedarf, die Abdichtung der Spalten 14s‴ ist somit nur zwischen Plattform 14‴ und Substrat notwendig.

An dieser Stelle sei angemerkt, dass die oben erläuterte Abstrahlstruktur nicht zwingend viereckig oder rechteckig sein muss, sondern auch jegliche andere Form, z. B. eine runde Form, eine Form mit 90°-Segmenten als Quadranten oder auch eine andere Form aufweisen kann. Auch kann die Abstrahlstruktur gewölbt sein bzw. eine 3d-Struktur aufweisen.

Ein weiteres Ausführungsbeispiel schafft ein Substrat mit einer Mehrzahl von Abstrahlstrukturen, die in das Substrat eingebettet sind.

Bei allen obigen Ausführungsbeispielen wäre es denkbar, dass die Blende in das Substrat integriert ist. Beispielsweise können die Wände der Kavität die Blende bilden, wenn sich die Abstrahlstruktur bei ihrem Hub vor allem innerhalb der Substratkavität, d. h. unterhalb der Oberfläche des Substrats befindet. Das kann beispielsweise dadurch erreicht werden, dass die Abstrahlstruktur vorgespannt ist.

Ein weiteres Ausführungsbeispiel schafft einen Mikrolautsprecher in MEMS-Technologie mit folgenden Merkmalen:
- (starre) Plattform, die eine Hubbewegung ausführt
- Plattform aufgehängt an einem Substrat
- Trennung der beweglichen Teile durch schmale Spalte
- Blendenstruktur, um die schmale Spalte auch bei Auslenkung zu erhalten,

Entsprechend Ausführungsbeispielen kann die Plattform beispielsweise durch piezoelektrische Biegeaktoren angetrieben sein, die gleichzeitig die Aufhängung der Plattform bilden.

Entsprechend Ausführungsbeispielen können Blendenstrukturen auf dem Substrat und/oder der bewegten Plattform ausgebildet sein.

Entsprechend Ausführungsbeispielen können Blendenstrukturen nach oben, unten oder in beide Richtungen ausgebildet sein.

In entsprechenden Ausführungsbeispielen erfolgt die Aufhängung der Plattform innerhalb sowie oberhalb oder unterhalb der Plattform.

Ein weiteres Ausführungsbeispiel schafft ein Herstellungsverfahren zur Herstellung des Mikrolautsprechers.

Alle oben genannten und erläuterten Ausführungsbeispiele haben den Vorteil, dass die Entkopplung der Antriebs- und Luftverteilungsfunktion eine getrennte Optimierung der einzelnen Komponenten erlaubt.

Als Anwendungsgebiet gilt generell der Bereich von Mikroschallwandlern, d. h. also Mikrolautsprecher und Mikrofone. Es sind neben Anwendungen im hörbaren Bereich (z. B. Mikrolautsprecher für Unterhaltungselektronik, Telekommunikation und Medizintechnik) auch Anwendungen im Ultraschallbereich denkbar.

### Literaturverzeichnis

[1] Patentanmeldung DE 10 2014 217 798, "Mikromechanische piezoelektrische Aktuatoren zur Realisierung hoher Kräfte und Auslenkungen"
[2] "Data Sheet Achelous, MEMS-based microspeaker for headphones, wearables and array applications", USound GmbH, 2018
[3] F. Stoppel, A. Männchen, F. Niekiel, D. Beer, T. Giese, B. Wagner, "New integrated full-range MEMS speaker for in-ear applications", IEEE Micro Electro Mechanical Systems (MEMS), 2018
[4] Patentschrift US 9 237 961 B2
[5] I. Shahosseini, E. Lefeuvre, J. Moulin, E. Martincic, M. Woytasik, G. Lemarquand, IEEE Sens. J. 13 (2013), pp. 273-284
[6] F. L. Ayatollahi, B. Y. Majlis, "Materials Design and Analysis of Low-Power MEMS Microspeaker Using Magnetic Actuation Technology", Adv. Mater. Res. 74 (2009), pp. 243-246
[7] Y. C. Chen, Y. T. Cheng, "A low-power milliwatt electromagnetic microspeaker using a PDMS membrane for hearing aids application", IEEE Int. Conf. Micro Electro Mech. Syst., 24th (2011), pp. 1213-1216
[8] M.-C. Cheng, W.-S. Huang, S. R.-S. Huang, "A silicon microspeaker for hearing instruments", J. Micromech. Microeng. 14 (2004), pp. 859-866
[9] S.-S. Je, F. Rivas, R. E. Diaz, J. Kwon, J. Kim, B. Bakkaloglu, S. Kiaei, J. Chae, "A Compact and Low-Cost MEMS Loudspeaker for Digital Hearing Aids", IEEE Trans. Biomed. Circ. Sys. 3 (2009), pp. 348-358
[10] B. Y. Majlis, G. Sugandi, M. M. Noor, "Compact electrodynamics MEMSspeaker", China Semiconductor Technology International Conference (CSTIC), 2017
[11] P. R. Jadhav, Y. T. Cheng, S. K. Fan, C. Y. Liang, "A sub-mW Electromagnetic Microspeaker with Bass Enhancement using Parylene/Graphene/Parylene Composite Membrane", IEEE Micro Electro Mechanical Systems (MEMS), 2018
[12] Albach, T. S., Horn, P., Sutor, A. & Lerch, R. Sound Generation Using a Magnetostrictive, Micro Actuator. J. Appl. Phys. 109(7), (2011)
[13] B. Kaiser, S. Langa, L. Ehrig, M. Stolz, H. Schenk, H. Conrad, H. Schenk, K Schimmanz, D. Schuffenhauer, Concept and proof for an all-silicon MEMS micro speaker utilizing air chambers, Microsystems & Nanoengineering (2019)
[14] Patentschrift US 10327060, "Air Pulse Generating Element and Sound Producing Device"

## Patentansprüche

1. MEMS-Schallwandler (10, 10', 10", 10‴) mit folgenden Merkmalen:
mindestens einem Aktor (16, 16a-16d, 16a"-16d", 16a‴-16d‴);
einer Abstrahlstruktur (14, 14', 14a-14d, 14", 14‴), die als separates Element mit dem Aktor (16, 16a-16d, 16a"-16d", 16a‴-16d‴) gekoppelt ist und ausgebildet ist;
eine die Abstrahlstruktur (14, 14', 14a-14d, 14", 14‴) umgebende Struktur (12), wobei die Abstrahlstruktur (14, 14', 14a-14d, 14", 14‴) durch einen oder mehrere Spalte (14s, 14s", 14s‴) von der umgebenden Struktur (12) getrennt ist; und
zumindest eine Blende (18, 18s", 18a", 18a, 18b, 18s‴), die entlang zumindest eines der einen oder mehreren Spalte (14s, 14s", 14s‴) angeordnet ist;
wobei die zumindest eine Blende (18, 18s", 18a", 18a, 18b, 18s‴) als Teil der Abstrahlstruktur (14, 14', 14a-14d, 14", 14‴) geformt ist

2. MEMS-Schallwandler (10, 10', 10", 10‴) gemäß Anspruch 1, wobei die Abstrahlstruktur (14, 14', 14a-14d, 14", 14‴) und die umgebende Struktur (12) in eine Ebene angeordnet ist; und/oder
wobei die umgebende Struktur (12) durch ein Substrat gebildet ist und die Abstrahlstruktur (14, 14', 14a-14d, 14", 14‴) sich in einer oder parallel zur Substratebene oder einer Kavität (12k) des Substrats befindet.

3. MEMS-Schallwandler (10, 10', 10", 10‴) gemäß einem der vorherigen Ansprüche, wobei die einen oder mehreren Spalte (14s, 14s", 14s‴) umlaufend um die Abstrahlstruktur (14, 14', 14a-14d, 14", 14‴) vorgesehen sind.

4. MEMS-Schallwandler (10, 10', 10", 10‴) gemäß einem der vorherigen Ansprüche,
wobei eine weitere Blende (18, 18s", 18a", 18a, 18b, 18s‴) sich in eine Substratebene hinein oder senkrecht in eine Substratebene hinein erstreckt; und/oder wobei eine weitere Blende (18, 18s", 18a", 18a, 18b, 18s‴) als Teil der umgebenden Struktur (12) geformt ist; und wobei die weiter Blende (18, 18s", 18a", 18a, 18b, 18s‴) sich aus einer Substratebene heraus oder senkrecht aus einer Substratebene heraus erstreckt oder wobei die weitere Blende (18, 18s", 18a", 18a, 18b, 18s‴) durch eine Kavität (12k) der umgebenden Struktur (12) gebildet ist.

5. MEMS-Schallwandler (10, 10', 10", 10‴) gemäß einem der vorherigen Ansprüche, wobei die Abstrahlstruktur (14, 14', 14a-14d, 14", 14‴) gegenüber der umgebenden Struktur (12) im Ruhezustand vorausgelenkt ist; und/oder
wobei die mindestens eine Blende (18, 18s", 18a", 18a, 18b, 18s‴) umlaufend um die Abstrahlstruktur (14, 14', 14a-14d, 14", 14‴) oder entlang der einen oder mehreren Spalte (14s, 14s", 14s‴) angeordnet ist.

6. MEMS-Schallwandler (10, 10', 10", 10‴) gemäß einem der vorherigen Ansprüche, wobei der Aktor (16, 16a-16d, 16a"-16d", 16a‴-16d‴) ein Biegeaktor oder ein Längsbiegeaktor oder einen Biegeaktor mit einem Aspektverhältnis von mindestens 5:1 umfasst; und/oder
wobei der Aktor (16, 16a-16d, 16a"-16d", 16a‴-16d‴) ein eingespanntes Ende oder ein freies Ende aufweist.

7. MEMS-Schallwandler (10, 10', 10", 10‴) gemäß Anspruch 6, wobei die Abstrahlstruktur (14, 14', 14a-14d, 14", 14‴) mit dem freien Ende des Biegewandlers gekoppelt ist oder im Bereich des freien Endes mit dem Biegewandler gekoppelt ist oder in Längsrichtung des Biegewandlers im Drittel näher am freien Ende als am eingespannten Ende gekoppelt ist.

8. MEMS-Schallwandler (10, 10', 10", 10‴) gemäß einem der vorherigen Ansprüche, wobei der Aktor (16, 16a-16d, 16a"-16d", 16a‴-16d‴) einen piezoelektrischen Aktor, elektrodynamischen Aktor (16, 16a-16d, 16a"-16d", 16a‴-16d‴) oder elektrostatischen Aktor (16, 16a-16d, 16a"-16d", 16a‴-16d‴) aufweist; und/oder wobei die Abstrahlstruktur (14, 14', 14a-14d, 14", 14‴) gegenüber der umgebenden Struktur (12) durch mindestens einen Aktor (16, 16a-16d, 16a"-16d", 16a‴-16d‴), Biegeaktor, Federelemente oder Federn gelagert ist; und/oder
wobei der mindestens eine Aktor (16, 16a-16d, 16a"-16d", 16a‴-16d‴) die Abstrahlstruktur (14, 14', 14a-14d, 14", 14‴) durch eine partiell flexible Struktur oder mehrere partiell flexible Strukturen verbunden ist; und/oder
wobei die Abstrahlstruktur (14, 14', 14a-14d, 14", 14‴) gegenüber der umgebenden Struktur (12) durch mindestens einen Aktor (16, 16a-16d, 16a"-16d", 16a‴-16d‴), Biegeaktor, Federelemente oder Federn gelagert ist oder durch mehrere Aktoren (16, 16a-16d, 16a"-16d", 16a‴-16d‴), mehrere Biegeaktoren, mehrere Federelemente oder mehrere Federn gelagert ist; und/oder
wobei die Abstrahlstruktur (14, 14', 14a-14d, 14", 14‴) gegenüber der umgebenden Struktur (12) durch mindestens einen Aktor (16, 16a-16d, 16a"-16d", 16a‴-16d‴), Biegeaktor, Federelemente oder Federn gelagert ist oder durch mehrere Aktoren (16, 16a-16d, 16a"-16d", 16a‴-16d‴), mehrere Biegeaktoren, mehrere Federelemente oder mehrere Federn gelagert ist, die sich entlang des Spalts oder in dem Spalt erstrecken.

9. MEMS-Schallwandler (10, 10', 10", 10‴) gemäß einem der vorherigen Ansprüche, wobei der mindestens eine Aktor (16, 16a-16d, 16a"-16d", 16a‴-16d‴) längs oder parallel entlang einer Kante der Abstrahlstruktur (14, 14', 14a-14d, 14", 14‴) angeordnet ist.

10. MEMS-Schallwandler gemäß einem der vorherigen Ansprüche, wobei die Abstrahlstruktur (14, 14', 14a-14d, 14", 14‴) zwei oder mehrere Bereiche aufweist, wobei zwischen den zwei oder mehreren Bereichen ein zentraler Bereich (14z) angeordnet ist.

11. MEMS-Schallwandler (10, 10', 10", 10‴) gemäß einem der vorherigen Ansprüche, wobei der mindestens eine Aktor (16, 16a-16d, 16a"-16d", 16a‴-16d‴) in einem zentralen Bereich (14z) mit der Abstrahlstruktur (14, 14', 14a-14d, 14", 14‴) gekoppelt ist; und/oder
wobei die mindestens zwei Aktoren (16, 16a-16d, 16a"-16d", 16a‴-16d‴) mit der Abstrahlstruktur (14, 14', 14a-14d, 14", 14‴) gekoppelt sind, und wobei die mindestens zwei Aktoren (16, 16a-16d, 16a"-16d", 16a‴-16d‴) gegenüberliegend angeordnet sind.

12. MEMS-Schallwandler (10, 10', 10", 10‴) gemäß einem der vorherigen Ansprüche, wobei zumindest eine weitere zusätzliche Blende (18, 18s", 18a", 18a, 18b, 18s‴) sich entlang eines Spalts zwischen dem mindestens einen Aktor (16, 16a-16d, 16a"-16d", 16a‴-16d‴) und einer Kante der Abstrahlstruktur (14, 14', 14a-14d, 14", 14‴) erstreckt; und/oder
wobei die Abstrahlstruktur (14, 14', 14a-14d, 14", 14‴) vier als Quadranten (14a-14d) angeordnete Bereiche aufweist,
wobei die vier als Quadranten (14a-14d) angeordnete Bereiche durch vier Aufhängungselemente oder Aktoren (16, 16a-16d, 16a"-16d", 16a‴-16d‴) unterbrochen sind, und/oder wobei die Aufhängungselemente oder Aktoren (16, 16a-16d, 16a"-16d", 16a‴-16d‴) mit einem zentralen Bereich (14z) zwischen den vier Quadranten (14a-14d) gekoppelt sind.

13. MEMS-Schallwandler (10, 10', 10", 10‴) gemäß einem der vorherigen Ansprüche, wobei die Abstrahlstruktur (14, 14', 14a-14d, 14", 14‴) ausgebildet ist, bei Betätigung durch den Aktor (16, 16a-16d, 16a"-16d", 16a‴-16d‴) eine Hubbewegung (B) in eine Richtung aus der Substratebene heraus durchzuführen.

14. Verfahren zur Herstellung eines MEMS-Schallwandler (10, 10', 10", 10‴) nach einem der vorherigen Ansprüche, mit folgenden Schritten:
Vorsehen von mindestens einem Aktor (16, 16a-16d, 16a"-16d", 16a‴-16d‴) sowie einer Abstrahlstruktur (14, 14', 14a-14d, 14", 14‴), die als separates Element mit dem Aktor (16, 16a-16d, 16a"-16d", 16a‴-16d‴) gekoppelt ist und ausgebildet ist, und einer die Abstrahlstruktur (14, 14', 14a-14d, 14", 14‴) umgebende Struktur (12), wobei die Abstrahlstruktur (14, 14', 14a-14d, 14", 14‴) durch einen oder mehrere Spalte (14s, 14s", 14s‴) von der umgebenden Struktur (12) getrennt ist; und
Anordnen von zumindest einer Blende (18, 18s", 18a", 18a, 18b, 18s‴) entlang zumindest eines der einen oder mehreren Spalte (14s, 14s", 14s‴).

15. MEMS-Schallwandler (10, 10', 10", 10‴) mit folgenden Merkmalen:
mindestens einem Aktor (16, 16a-16d, 16a"-16d", 16a‴-16d‴);
einer Abstrahlstruktur (14, 14', 14a-14d, 14", 14‴), die als separates Element mit dem Aktor (16, 16a-16d, 16a"-16d", 16a‴-16d‴) gekoppelt ist und ausgebildet ist;
eine die Abstrahlstruktur (14, 14', 14a-14d, 14", 14‴) umgebende Struktur (12), wobei die Abstrahlstruktur (14, 14', 14a-14d, 14", 14‴) durch einen oder mehrere Spalte (14s, 14s", 14s‴) von der umgebenden Struktur (12) getrennt ist; und
zumindest eine Blende (18, 18s", 18a", 18a, 18b, 18s‴), die entlang zumindest eines der einen oder mehreren Spalte (14s, 14s", 14s‴) angeordnet ist;
wobei die mindestens eine Blende (18, 18s", 18a", 18a, 18b, 18s‴) als Teil der umgebenden Struktur (12) und durch eine Kavität (12k) der umgebenden Struktur (12) geformt ist; und wobei die mindestens eine Blende (18, 18s", 18a", 18a, 18b, 18s‴) sich aus einer Substratebene heraus oder senkrecht aus einer Substratebene heraus erstreckt und wobei die mindestens eine Blende (18, 18s", 18a", 18a, 18b, 18s‴) einen Rand der Kavität (12k) verlängert.

## Claims

1. An MEMS sound transducer (10, 10', 10", 10"') comprising:
at least one actuator (16, 16a-16d, 16a"-16d", 16a‴-16d‴);
a radiation structure (14, 14', 14a-14d, 14", 14"') coupled to the actuator (16, 16a-16d, 16a"-16d", 16a‴-16d‴) and configured as a separate element;
a structure (12) surrounding the radiation structure (14, 14', 14a-14d, 14", 14‴), wherein the radiation structure (14, 14', 14a-14d, 14", 14"') is separated from the surrounding structure (12) by one or more gaps (14s, 14s", 14s‴); and
at least one screen (18, 18s", 18a", 18a, 18b, 18s‴) arranged along at least one of the one or more gaps (14s, 14s", 14s‴),
wherein the at least one screen (18, 18s", 18a", 18a, 18b, 18s"') is formed as part of the radiation structure (14, 14', 14a-14d, 14" 14"').

2. The MEMS sound transducer (10, 10', 10", 10‴) in accordance with claim 1, wherein the radiation structure (14, 14', 14a-14d, 14", 14"') and the surrounding structure (12) are arranged in one plane; and/or
wherein the surrounding structure (12) is formed by a substrate and the radiation structure (14, 14', 14a-14d, 14", 14"') is located in or in parallel to a substrate plane or cavity (12k) of the substrate.

3. The MEMS sound transducer (10, 10', 10", 10‴) in accordance with any of the preceding claims, wherein the one or more gaps (14s, 14s", 14s‴) are provided circumferentially around the radiation structure (14, 14', 14a-14d, 14", 14‴).

4. The MEMS sound transducer (10, 10', 10", 10‴) in accordance with any of the preceding claims,
wherein a further screen (18, 18s", 18a", 18a, 18b, 18s"') extends into a substrate plane or perpendicularly into a substrate plane; and/or
wherein the further screen (18, 18s", 18a", 18a, 18b, 18s"') is formed as part of the surrounding structure (12); and wherein the further screen (18, 18s", 18a", 18a, 18b, 18s‴) extends out of the substrate plane or perpendicularly out of a substrate plane; or wherein the further screen (18, 18s", 18a", 18a, 18b, 18s"') is formed by a cavity (12k) of the surrounding structure (12).

5. The MEMS sound transducer (10, 10', 10", 10‴) in accordance with any of the preceding claims, wherein the radiation structure (14, 14', 14a-14d, 14" 14‴) is pre-deflected relative to the surrounding structure (12) in an idle state; and/or
wherein the at least one screen (18, 18s", 18a", 18a, 18b, 18s"') is arranged to be circumferential around the radiation structure (14, 14', 14a-14d, 14", 14‴) or along the one or more gaps (14s, 14s", 14s"').

6. The MEMS sound transducer (10, 10', 10", 10‴) in accordance with any of the preceding claims, wherein the actuator (16, 16a-16d, 16a"-16d", 16a‴-16d‴) comprises a bending actuator or a longitudinal bending actuator or a bending actuator having an aspect ratio of at least 5:1; and/or
wherein the actuator (16, 16a-16d, 16a"-16d", 16a‴-16d‴) comprises a clamped end or a free end.

7. The MEMS sound transducer (10, 10', 10", 10‴) in accordance with claim 6, wherein the radiation structure (14, 14', 14a-14d, 14" 14‴) is coupled to the free end of the bending transducer or coupled to the bending transducer in the region of the free end or coupled in the longitudinal direction of the bending transducer in the third closer to the free end than to the clamped end.

8. The MEMS sound transducer (10, 10', 10", 10‴) in accordance with any of the preceding claims, wherein the actuator (16, 16a-16d, 16a"-16d", 16a‴-16d‴) comprises a piezoelectric actuator, electrodynamic actuator (16, 16a-16d, 16a"-16d", 16a‴-16d‴) or electrostatic actuator (16, 16a-16d, 16a"-16d", 16a‴-16d‴); and/or
wherein the radiation structure (14, 14', 14a-14d, 14" 14‴) is supported relative to the surrounding structure (12) by at least one actuator (16, 16a-16d, 16a"-16d", 16a‴-16d‴), bending actuator, spring elements or springs; and/or
wherein the at least one actuator (16, 16a-16d, 16a"-16d", 16a‴-16d‴) connects the radiation structure (14, 14', 14a-14d, 14" 14"') by a partially flexible structure or several partially flexible structures; and/or
wherein the radiation structure (14, 14', 14a-14d, 14" 14‴) is supported relative to the surrounding structure (12) by at least one actuator (16, 16a-16d, 16a"-16d", 16a‴-16d‴), bending actuators, spring elements or springs or is supported by several actuators (16, 16a-16d, 16a"-16d", 16a‴-16d‴), several bending actuators, several spring elements or several springs; and/or
wherein the radiation structure (14, 14', 14a-14d, 14" 14‴) is supported relative to the surrounding structure (12) by at least one actuator (16, 16a-16d, 16a"-16d", 16a‴-16d‴), bending actuator, spring elements or springs or is supported by several actuators (16, 16a-16d, 16a"-16d", 16a‴-16d‴), several bending actuators, several spring elements or several springs which extend along the gap or in the gap.

9. The MEMS sound transducer (10, 10', 10", 10‴) in accordance with any of the preceding claims, wherein the at least one actuator (16, 16a-16d, 16a"-16d", 16a"'-16d‴) is arranged alongside or in parallel along an edge of the radiation structure (14, 14', 14a-14d, 14" 14"').

10. The MEMS sound transducer in accordance with any of the preceding claims, wherein the radiation structure (14, 14', 14a-14d, 14" 14"') comprises two or more regions, wherein a central region (14z) is arranged between the two or more regions.

11. The MEMS sound transducer (10, 10', 10", 10‴) in accordance with any of the preceding claims, wherein the at least one actuator (16, 16a-16d, 16a"-16d", 16a"'-16d‴) is coupled to the radiation structure (14, 14', 14a-14d, 14" 14"') in a central region (14z); and/or
wherein the at least two actuators (16, 16a-16d, 16a"-16d", 16a‴-16d‴) are coupled to the radiation structure (14, 14', 14a-14d, 14" 14"'), and wherein the at least two actuators (16, 16a-16d, 16a"-16d", 16a‴-16d‴) are arranged to be opposite.

12. The MEMS sound transducer (10, 10', 10", 10‴) in accordance with any of the preceding claims, wherein at least one further additional screen (18, 18s", 18a", 18a, 18b, 18s"') extends along a gap between the at least one actuator (16, 16a-16d, 16a"-16d", 16a‴-16d‴) and an edge of the radiation structure (14, 14', 14a-14d, 14" 14‴); and/or
wherein the radiation structure (14, 14', 14a-14d, 14" 14"') comprises four regions arranged as quadrants (14a-14d),
wherein the four regions arranged as quadrants (14a-14d) are interrupted by four suspension elements or actuators (16, 16a-16d, 16a"-16d", 16a‴-16d‴), and/or wherein the suspension elements or actuators (16, 16a-16d, 16a"-16d", 16a"'-16d‴) are coupled to a central region (14z) between the four quadrants (14a-14d).

13. The MEMS sound transducer (10, 10', 10", 10‴) in accordance with any of the preceding claims, wherein the radiation structure (14, 14', 14a-14d, 14" 14"') is configured to perform, when actuated by the actuator (16, 16a-16d, 16a"-16d", 16a‴-16d‴), a stroke movement (B) in a direction out of the substrate plane.

14. A method for manufacturing an MEMS sound transducer (10, 10', 10", 10‴) in accordance with any of the preceding claims, comprising:
providing at least one actuator (16, 16a-16d, 16a"-16d", 16a‴-16d‴) and a radiation structure (14, 14', 14a-14d, 14" 14‴) which is coupled to the actuator (16, 16a-16d, 16a"-16d", 16a‴-16d‴) and configured as a separate element, and a structure (12) surrounding the radiation structure (14, 14', 14a-14d, 14" 14‴), wherein the radiation structure (14, 14', 14a-14d, 14" 14‴) is separated from the surrounding structure (12) by one or more gaps (14s, 14s", 14s‴); and
arranging at least one screen (18, 18s", 18a", 18a, 18b, 18s"') along at least one of the one or more gaps (14s, 14s", 14s"').

15. An MEMS sound transducer (10, 10', 10", 10"') comprising:
at least one actuator (16, 16a-16d, 16a"-16d", 16a‴-16d‴);
a radiation structure (14, 14', 14a-14d, 14", 14"') coupled to the actuator (16, 16a-16d, 16a"-16d", 16a‴-16d‴) and configured as a separate element;
a structure (12) surrounding the radiation structure (14, 14', 14a-14d, 14", 14‴), wherein the radiation structure (14, 14', 14a-14d, 14", 14"') is separated from the surrounding structure (12) by one or more gaps (14s, 14s", 14s‴); and
at least one screen (18, 18s", 18a", 18a, 18b, 18s‴) arranged along at least one of the one or more gaps (14s, 14s", 14s‴),
wherein the at least one screen (18, 18s", 18a", 18a, 18b, 18s"') is formed as part of the surrounding structure (12) and by a cavity (12k) of the surrounding structure (12); and wherein the at least one screen (18, 18s", 18a", 18a, 18b, 18s"') extends out of a substrate plane or perpendicularly out of a substrate plane, and wherein the at least one screen (18, 18s", 18a", 18a, 18b, 18s"') extends an edge of the cavity (12k).

## Revendications

1. Transducteur acoustique MEMS (10, 10', 10", 10‴) comportant les caractéristiques suivantes :
au moins un actionneur (16, 16a-16d, 16a"-16d", 16a"'-16d"') ;
une structure d'émission (14, 14', 14a-14d, 14", 14‴) qui est conçue en tant qu'élément séparé de l'actionneur (16, 16a-16d, 16a"-16d", 16a‴-16d‴) et est accouplée à celui-ci ;
une structure (12) enveloppant la structure d'émission (14, 14', 14a-14d, 14", 14‴), dans lequel la structure d'émission (14, 14', 14a-14d, 14", 14‴) est séparée de la structure enveloppante (12) par une ou plusieurs fentes (14s, 14s", 14s‴) ; et
au moins un panneau (18, 18s", 18a", 18a, 18b, 18s"') qui est disposé le long d'au moins l'une parmi la ou les fentes (14s, 14s", 14s"') ;
dans lequel l'au moins un panneau (18, 18s", 18a", 18a, 18b, 18s‴) est formé en tant que partie de la structure d'émission (14, 14', 14a-14d, 14", 14‴).

2. Transducteur acoustique MEMS (10, 10', 10", 10‴) selon la revendication 1, dans lequel la structure d'émission (14, 14', 14a-14d, 14", 14‴) et la structure enveloppante (12) sont disposées dans un plan ; et/ou
dans lequel la structure enveloppante (12) est formée par un substrat et la structure d'émission (14, 14', 14a-14d, 14", 14‴) se trouve dans un plan de substrat ou parallèlement au plan de substrat ou à une cavité (12k) du substrat.

3. Transducteur acoustique MEMS (10, 10', 10", 10‴) selon l'une des revendications précédentes, dans lequel la ou les fentes (14s, 14s", 14s"') sont prévues de manière circonférentielle autour de la structure d'émission (14, 14', 14a-14d, 14", 14‴).

4. Transducteur acoustique MEMS (10, 10', 10", 10‴) selon l'une des revendications précédentes,
dans lequel un autre panneau (18, 18s", 18a", 18a, 18b, 18s‴) s'étend dans un plan de substrat ou perpendiculairement dans un plan de substrat ; et/ou
dans lequel un autre panneau (18, 18s", 18a", 18a, 18b, 18s‴ est formé en tant que partie de la structure enveloppante (12) ; et dans lequel l'autre panneau (18, 18s", 18a", 18a, 18b, 18s‴) s'étend hors d'un plan de substrat ou perpendiculairement hors d'un plan de substrat ou dans lequel l'autre panneau (18, 18s", 18a", 18a, 18b, 18s‴) est formé par une cavité (12k) de la structure enveloppante (12).

5. Transducteur acoustique MEMS (10, 10', 10", 10‴) selon l'une des revendications précédentes, dans lequel la structure d'émission (14, 14', 14a-14d, 14", 14‴) est pré-déviée par rapport à la structure enveloppante (12) à l'état de repos ; et/ou
dans lequel l'au moins un panneau (18, 18s", 18a", 18a, 18b, 18s‴) est disposé de manière circonférentielle autour de la structure d'émission (14, 14', 14a-14d, 14", 14‴) ou le long de la ou des fentes (14s, 14s", 14s"').

6. Transducteur acoustique MEMS (10, 10', 10", 10‴) selon l'une des revendications précédentes, dans lequel l'actionneur (16, 16a-16d, 16a"-16d", 16a‴-16d‴) comprend un actionneur de flexion ou un actionneur de flexion longitudinale ou un actionneur de flexion comportant un rapport d'aspect d'au moins 5:1 ; et/ou
dans lequel l'actionneur (16, 16a-16d, 16a"-16d", 16a‴-16d‴) présente une extrémité serrée ou une extrémité libre.

7. Transducteur acoustique MEMS (10, 10', 10", 10‴) selon la revendication 6, dans lequel la structure d'émission (14, 14', 14a-14d, 14", 14‴) est accouplée à l'extrémité libre du transducteur de flexion ou est accouplée au transducteur de flexion dans la zone de l'extrémité libre ou est accouplée, dans la direction longitudinale du transducteur de flexion, dans le tiers plus proche de l'extrémité libre que de l'extrémité serrée.

8. Transducteur acoustique **MEMS** (10, 10', 10", 10‴) selon l'une des revendications précédentes, dans lequel l'actionneur (16, 16a-16d, 16a"-16d", 16a‴-16d‴) présente un actionneur piézoélectrique, un actionneur électrodynamique (16, 16a-16d, 16a"-16d", 16a"'-16d"') ou un actionneur électrostatique (16, 16a-16d, 16a"-16d", 16a‴-16d‴) ; et/ou
dans lequel la structure d'émission (14, 14', 14a-14d, 14", 14‴) est montée par rapport à la structure enveloppante (12) au moyen d'au moins un actionneur (16, 16a-16d, 16a"-16d", 16a‴-16d‴), d'un actionneur de flexion, d'éléments élastiques ou de ressorts ; et/ou
dans lequel l'au moins un actionneur (16, 16a-16d, 16a"-16d", 16a‴-16d‴) est relié à la structure d'émission (14, 14', 14a-14d, 14", 14‴) au moyen d'une structure partiellement flexible ou de plusieurs structures partiellement flexibles ; et/ou
dans lequel la structure d'émission (14, 14', 14a-14d, 14", 14‴) est montée par rapport à la structure enveloppante (12) au moyen d'au moins un actionneur (16, 16a-16d, 16a"-16d", 16a‴-16d‴), d'un actionneur de flexion, d'éléments élastiques ou de ressorts ou est montée au moyen de plusieurs actionneurs (16, 16a-16d, 16a"-16d", 16a‴-16d‴), de plusieurs actionneurs de flexion, de plusieurs éléments élastiques ou de plusieurs ressorts ; et/ou
dans lequel la structure d'émission (14, 14', 14a-14d, 14", 14‴) est montée par rapport à la structure enveloppante (12) au moyen d'au moins un actionneur (16, 16a-16d, 16a"-16d", 16a‴-16d‴), d'un actionneur de flexion, d'éléments élastiques ou de ressorts ou est montée au moyen de plusieurs actionneurs (16, 16a-16d, 16a"-16d", 16a‴-16d‴), de plusieurs actionneurs de flexion, de plusieurs éléments élastiques ou de plusieurs ressorts qui s'étendent le long de la fente ou dans la fente.

9. Transducteur acoustique MEMS (10, 10', 10", 10‴) selon l'une des revendications précédentes, dans lequel l'au moins un actionneur (16, 16a-16d, 16a"-16d", 16a‴-16d‴) est disposé longitudinalement ou parallèlement le long d'un bord de la structure d'émission (14, 14', 14a-14d, 14", 14‴).

10. Transducteur acoustique MEMS selon l'une des revendications précédentes, dans lequel la structure d'émission (14, 14', 14a-14d, 14", 14‴) présente deux zones ou plus, dans lequel une zone centrale (14z) est disposée entre les deux zones ou plus.

11. Transducteur acoustique MEMS (10, 10', 10", 10‴) selon l'une des revendications précédentes, dans lequel l'au moins un actionneur (16, 16a-16d, 16a"-16d", 16a‴-16d‴) est accouplé à la structure d'émission (14, 14', 14a-14d, 14", 14‴) dans une zone centrale (14z) ; et/ou
dans lequel les au moins deux actionneurs (16, 16a-16d, 16a"-16d", 16a‴-16d‴) sont accouplés à la structure d'émission (14, 14', 14a-14d, 14", 14‴), et dans lequel les au moins deux actionneurs (16, 16a-16d, 16a"-16d", 16a‴-16d‴) sont disposés de manière à être opposés.

12. Transducteur acoustique MEMS (10, 10', 10", 10‴) selon l'une des revendications précédentes, dans lequel au moins un autre panneau supplémentaire (18, 18s", 18a", 18a, 18b, 18s"') s'étend le long d'une fente entre l'au moins un actionneur (16, 16a-16d, 16a"-16d", 16a‴-16d‴) et un bord de la structure d'émission (14, 14', 14a-14d, 14", 14‴) ; et/ou
dans lequel la structure d'émission (14, 14', 14a-14d, 14", 14‴) présente quatre zones disposées en tant que quadrants (14a-14d),
dans lequel les quatre zones disposées en tant que quadrants (14a-14d) sont interrompues par quatre éléments de suspension ou actionneurs (16, 16a-16d, 16a"-16d", 16a‴-16d‴), et/ou dans lequel les éléments de suspension ou actionneurs (16, 16a-16d, 16a"-16d", 16a‴-16d‴) sont accouplés à une zone centrale (14z) entre les quatre quadrants (14a-14d).

13. Transducteur acoustique MEMS (10, 10', 10", 10‴) selon l'une des revendications précédentes, dans lequel la structure d'émission (14, 14', 14a-14d, 14", 14‴) est conçue pour effectuer un mouvement de levage (B) dans une direction hors du plan de substrat lors de l'actionnement par l'actionneur (16, 16a-16d, 16a"-16d", 16a‴-16d‴).

14. Procédé pour la fabrication d'un transducteur acoustique MEMS (10, 10', 10", 10‴) selon l'une des revendications précédentes, comportant les étapes suivantes :
prévision d'au moins un actionneur (16, 16a-16d, 16a"-16d", 16a‴-16d‴) ainsi que d'une structure d'émission (14, 14', 14a-14d, 14", 14‴) qui est conçue en tant qu'élément séparé de l'actionneur (16, 16a-16d, 16a"-16d", 16a‴-16d‴) et est accouplée à celui-ci, et d'une structure (12) enveloppant la structure d'émission (14, 14', 14a-14d, 14", 14‴), dans lequel la structure d'émission (14, 14', 14a-14d, 14", 14‴) est séparée de la structure enveloppante (12) par une ou plusieurs fentes (14s, 14s", 14s"') ; et
disposition d'au moins un panneau (18, 18s", 18a", 18a, 18b, 18s"') le long d'au moins l'une parmi la ou les fentes (14s, 14s", 14s‴).

15. Transducteur acoustique MEMS (10, 10', 10", 10‴) comportant les caractéristiques suivantes :
au moins un actionneur (16, 16a-16d, 16a"-16d", 16a‴-16d‴) ;
une structure d'émission (14, 14', 14a-14d, 14", 14‴) qui est conçue en tant qu'élément séparé de l'actionneur (16, 16a-16d, 16a"-16d", 16a‴-16d‴) et est accouplée à celui-ci ;
une structure (12) enveloppant la structure d'émission (14, 14', 14a-14d, 14", 14‴), dans lequel la structure d'émission (14, 14', 14a-14d, 14", 14‴) est séparée de la structure enveloppante (12) par une ou plusieurs fentes (14s, 14s", 14s‴) ; et
au moins un panneau (18, 18s", 18a", 18a, 18b, 18s"') qui est disposé le long d'au moins l'une parmi la ou les fentes (14s, 14s", 14s"') ;
dans lequel l'au moins un panneau (18, 18s", 18a", 18a, 18b, 18s‴) est formé en tant que partie de la structure enveloppante (12) et par une cavité (12k) de la structure enveloppante (12) ; et dans lequel l'au moins un panneau (18, 18s", 18a", 18a, 18b, 18s‴) s'étend hors d'un plan de substrat ou perpendiculairement hors d'un plan de substrat, et dans lequel l'au moins un panneau (18, 18s", 18a", 18a, 18b, 18s‴) prolonge un bord de la cavité (12k).
